(19) Europäisches Patentamt
European Patent Office
Office européen des brevets

(11) **EP 2 700 156 B1**

(12) **EUROPÄISCHE PATENTSCHRIFT**

(45) Veröffentlichungstag und Bekanntmachung des Hinweises auf die Patenterteilung:
**07.01.2015 Patentblatt 2015/02**

(51) Int Cl.:
*H02M 7/5387* (2007.01)   *H02P 6/00* (2006.01)
*H02P 27/08* (2006.01)   *G01R 19/00* (2006.01)
*H02M 7/5395* (2006.01)   *H02M 1/00* (2007.01)

(21) Anmeldenummer: **12701526.1**

(22) Anmeldetag: **31.01.2012**

(86) Internationale Anmeldenummer:
**PCT/EP2012/051576**

(87) Internationale Veröffentlichungsnummer:
**WO 2012/107325 (16.08.2012 Gazette 2012/33)**

(54) **VERFAHREN UND VORRICHTUNG ZUR STROMMESSUNG**

METHOD AND APPARATUS FOR MEASURING CURRENT

PROCÉDÉ ET DISPOSITIF DE MESURE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.02.2011 DE 102011003897**

(43) Veröffentlichungstag der Anmeldung:
**26.02.2014 Patentblatt 2014/09**

(73) Patentinhaber: **Robert Bosch GmbH**
**70442 Stuttgart (DE)**

(72) Erfinder:
• SCHILL, Georg
  75181 Pforzheim (DE)
• URBAN, Stephan
  73275 Ohmden (DE)
• ECKSTEIN, Oliver
  70736 Fellbach (DE)

(56) Entgegenhaltungen:
EP-A1- 0 798 847      EP-A1- 0 822 648
EP-A1- 1 347 567      EP-A2- 1 617 555
WO-A1-03/105329      WO-A1-2008/055741
US-A1- 2006 071 627

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Strommessung in einem mehrphasigen, insbesondere dreiphasigen Stromnetz, bei dem durch mittels Ansteuersignale steuerbaren Schaltelementen eine gewünschte Bestromung eines elektrischen Verbrauchers erfolgt, wobei die Strommessung mit nur einem einzigen Shunt erfolgt und Taktmustern der Ansteuersignale Messfenster zur sequenziellen Strommessung von Phasenströmen zugeordnet sind und die Taktmuster zeitlich verschoben werden, um Messfenster ausreichender zeitlicher Größe zu erhalten, und um die Sektorlage eines durch die Strommessung bewirkten Strommessvektors in Abhängigkeit von der momentanen Sektorposition des Phasenvektors zu bestimmen.

Ferner betrifft die Erfindung eine Vorrichtung zur Strommessung in einem mehrphasigen, insbesondere dreiphasigen Stromnetz, insbesondere zur Durchführung des oben beschriebenen Verfahrens, mit mehreren steuerbaren Schaltelementen zur gewünschten Bestromung eines Verbrauchers, sowie mit einem einzigen Shunt zur Stromerfassung und mit einer Ansteuereinheit zum Ansteuern der Schaltelemente mittels Ansteuersignalen, wobei Taktmustern der Ansteuersignale Messfenster zur sequenziellen Strommessung von Phasenströmen zugeordnet sind und die Taktmuster zeitlich verschoben werden, um Messfenster ausreichender zeitlicher Größe zu erhalten, und um die Sektorlage eines durch die Strommessung bewirkten Strommessvektors in Abhängigkeit von der momentanen Sektorposition des Phasenvektors zu bestimmen.

Stand der Technik

Verfahren und Vorrichtungen der eingangs genannten Art sind aus dem Stand der Technik bekannt.

Bei Elektromotoren mit mehrphasiger Ansteuerung besteht oft der Wunsch, die Phasenströme zu erfassen. Handelt es sich um eine Bestromung eines Elektromotors mittels einer steuerbaren Brücke, die in ihren einzelnen Brückenzweigen steuerbare Schaltelemente aufweist, so lässt sich der Elektromotor in gewünschter Weise bestromen. Um die Phasenströme zu erfassen, wird in jeder Phasenleitung ein niederohmiger Widerstand, der sogenannte Shunt, angeordnet. Der Aufwand dieser mehrphasigen Messanordnung ist entsprechend groß.

Weiterhin sind Verfahren und Vorrichtungen bekannt, bei denen die Strommessung mit nur einem einzigen Shunt erfolgt, wobei in sequenzieller Folge die Phasenströme ermittelt werden. Dabei ist es ausreichend, bei beispielsweise einer Drei-Phasen-Anordnung nur zwei Phasen zu messen und den Strom der dritten Phase mithilfe der Kirchhoffschen Gesetze zu berechnen. Dazu werden steuerbare Schaltelemente insbesondere in der Form einer Brückenschaltung eingesetzt, die einen Gleichstromzwischenkreis aufweist, wobei der Strom durch den gemeinsamen Shunt in der Zu- beziehungsweise Rückleitung vom/zum Zwischenkreis fließt und dem zu messenden Phasenstrom entspricht.

Aus der WO 2008/055741 sind beispielsweise ein Verfahren sowie eine Vorrichtung zur Strommessung in einem mehrphasigen Stromnetz bekannt, bei der die Taktmuster entsprechend zeitlich verschoben werden, wodurch insbesondere die Belastung des Gleichstromzwischenkreises sowie die Geräuschentwicklung verringert werden. Durch das Verschieben der Taktmuster werden Messfenster ausreichender zeitlicher Größe erhalten, die es also erlauben, die Phasenströme zu messen. Darüber hinaus werden die Taktmuster derart verschoben, dass die Sektorlage eines durch die Strommessung bewirkten Strommessvektors in Abhängigkeit von der momentanen Sektorposition des Phasenvektors, insbesondere von der momentanen Drehwinkelposition des Phasenvektors, bestimmt beziehungsweise eingestellt wird. Unter Sektoren sind hierbei insbesondere mögliche Sektoren eines die Strommessvektoren und den Phasenvektor darstellenden Zeigerdiagramms zu verstehen. Nachteilig bei den bekannten Verfahren und Vorrichtungen ist die Geräuschentwicklung, die durch das Umschalten des Strommessvektors entsteht. Insbesondere bei niederinduktiven elektrischen Maschinen führt das direkte Umschalten zu einem störend wahrnehmbaren Geräusch, da der Motor durch die Spannungsanregung angeregt wird. Insbesondere bei Synchronmaschinen, insbesondere Permanent-Synchronmaschinen, kann diese Anregung störend wirken.

Offenbarung der Erfindung

Das erfindungsgemäße Verfahren zeichnet sich durch die Merkmale des Anspruchs 1 aus und hat den Vorteil, dass die Geräuschentwicklung weiter gesenkt wird. Dazu ist erfindungsgemäß vorgesehen, dass nach einer erfolgten Strommessung beim Umschalten des Stromvektors von einem Sektor in einen anderen Sektor die Taktmuster in Teilschritten über mehrere Takte hinweg zeitlich verschoben werden und die folgende Strommessung erst bei Erreichen des bestimmten Strommessvektors erfolgt. Es ist also vorgesehen, dass nicht in jedem Takt beziehungsweise jeder Schaltperiode eine Strommessung erfolgt, und dass in den strommessungsfreien Takten das Umschalten des Stromvektors langsam beziehungsweise in mehreren Teilschritten erfolgt, wobei das vollständige Verschieben auf die zwischen den zwei Strommessungen liegenden Takten vorzugsweise gleichmäßig aufgeteilt wird. Im Zusammenhang der vorliegenden Anmeldung bedeutet ein Verschieben stets ein zeitliches Verschieben. Der Strommessvektor wird also weiterhin in Abhängigkeit des Phasenvektors von Sektor zu Sektor geschaltet, wobei erfindungsgemäß ein weiches beziehungsweise langsames Umschalten erfolgt. Damit wird der elektrische Verbraucher, insbesondere der elektrische Motor, nicht oder weniger stark angeregt, sodass insbesondere die Geräuschentwicklung reduziert wird.

Vorzugsweise erfolgt die Strommessung alle x + 1 Takte, mit x > 0. Besonders bevorzugt erfolgt die Strommessung alle vier Takte, sodass das Umschalten des Stromvektors zweckmäßigerweise über vier Takte aufgeteilt wird. Dazu wird die zeitliche Gesamtverschiebung in die zeitlichen Teilschritte beziehungsweise Teilverschiebungen auf die vier Takte aufgeteilt.

Vorzugsweise wird die minimale zeitliche Verschiebung der Messfenster aus der Summe von einer minimalen Totzeit des Schaltelements, einer minimalen Einschwingzeit einer Messverstärkerschaltung und einer minimalen Abtastzeit eines Analog-Digital-Wandlers zusammengesetzt. Die Messverstärkerschaltung und der Analog-Digital-Wandler werden dem Shunt zugeordnet, um den vom Shunt erfassten Strom abzugreifen. Bevorzugt werden als Ansteuersignale Pulsweitenmodulationssignale eingesetzt. Die Ansteuerung der steuerbaren Schaltelemente erfolgt demgemäß mittels Pulsweitenmodulation, wobei aufgrund des erfindungsgemäßen Vorgehens keine symmetrische, sondern eine asymmetrische Pulsweitenmodulation (PWM) vorliegt.

Vorzugsweise wird als Verbraucher ein insbesondere mehrphasiger Asynchronmotor oder ein insbesondere mehrphasiger Permanentmagnet-Synchronmotor bestromt. Der Verbraucher, insbesondere die genannten Motoren, sind bevorzugt in Stern geschaltet.

Ferner ist es vorteilhaft, wenn in je einem Messfenster die Messung eines Phasenstroms des Verbrauchers erfolgt. Die Messung der einzelnen Phasenströme erfolgt demgemäß zeitlich nacheinander.

Besonders bevorzugt wird der Strommessvektor derart umgeschaltet, dass er mit dem Phasenvektor beziehungsweise mit dessen Drehwinkelposition mitrotiert. In Abhängigkeit der momentanen Sektorlage beziehungsweise Drehwinkelposition des Phasenvektors wird demgemäß die Strommessung durchgeführt, sodass nicht nur der Phasenvektor rotiert, sondern auch der bewirkte Strommessvektor. Der bewirkte Strommessvektor ergibt sich durch die vektorielle Addition der Stromvektoren der jeweiligen Strommessung eines Fensters. Der Phasenvektor resultiert vorzugsweise aus der Kombination eines momentenstellenden und feldbildenden Vektors.

Gemäß einer vorteilhaften Weiterbildung der Erfindung ist vorgesehen, dass als Schaltelemente elektronische Bauteile, insbesondere Transistoren, vorzugsweise Feldeffekttransistoren (FET) und/oder Thyristoren, eingesetzt werden. Diese Schaltelemente weisen Steuereingänge auf, an die die Ansteuersignale angelegt werden, wodurch die Schaltzustände der Schaltelemente verändert werden. Zweckmäßigerweise ist zum Ansteuern eine Ansteuereinheit vorgesehen, die mit den Steuereingängen der Schaltelemente verbunden ist. Bevorzugt bilden die Schaltelemente eine Brückenschaltung zum Bestromen des Verbrauchers.

Die erfindungsgemäße Vorrichtung zeichnet sich dadurch aus, dass nach einer erfolgten Strommessung beim Umschalten des Stromvektors von einem Sektor in einen anderen Sektor die Taktmuster in Teilschritten über mehrere Takte hinweg verschoben werden und die folgende Strommessung erst bei Erreichen des bestimmten Strommessvektors erfolgt. Hieraus ergeben sich die oben bereits genannten Vorteile. Vorzugsweise sind als Schaltelemente elektronische Bauelemente, insbesondere Transistoren, vorzugsweise Feldeffekttransistoren und/oder Thyristoren, wie oben bereits beschrieben, vorgesehen.

Die Bestromung des Verbrauchers erfolgt vorzugsweise mit einer steuerbaren Brückenschaltung, die besonders bevorzugt aus den Schaltelementen zusammengesetzt ist. Besonders bevorzugt wird hierbei eine B6-Brücke zum Einsatz gebracht, wenn der Verbraucher ein dreiphasiger Verbraucher in Sternschaltung ist, insbesondere ein entsprechender Asynchronmotor oder Permanentmagnet-Synchronmotor.

Die Brückenschaltung weist zweckmäßigerweise einen Gleichstromkreis auf, insbesondere Gleichstromzwischenkreis, von dem sie gespeist wird. Das von dem Shunt ausgegebene Signal wird vorzugsweise mittels eines Messverstärkers verstärkt und mittels eines Analog-Digital-Wandlers umgesetzt und steht somit für verschiedene Zwecke zur Verfügung.

Im Folgenden soll die Erfindung anhand der Zeichnung näher erläutert werden. Dazu zeigen

Figur 1                 ein Schaltbild einer Vorrichtung zur Strommessung,

Figuren 2 bis 5         Diagramme, die bekannte Verfahren wiedergeben,

Figur 6A und 6B         ein Umschalten des Strommessvektors gemäß dem Stand der Technik und

Figuren 7A bis 7E       ein bevorzugtes Umschalten eines Strommessvektors.

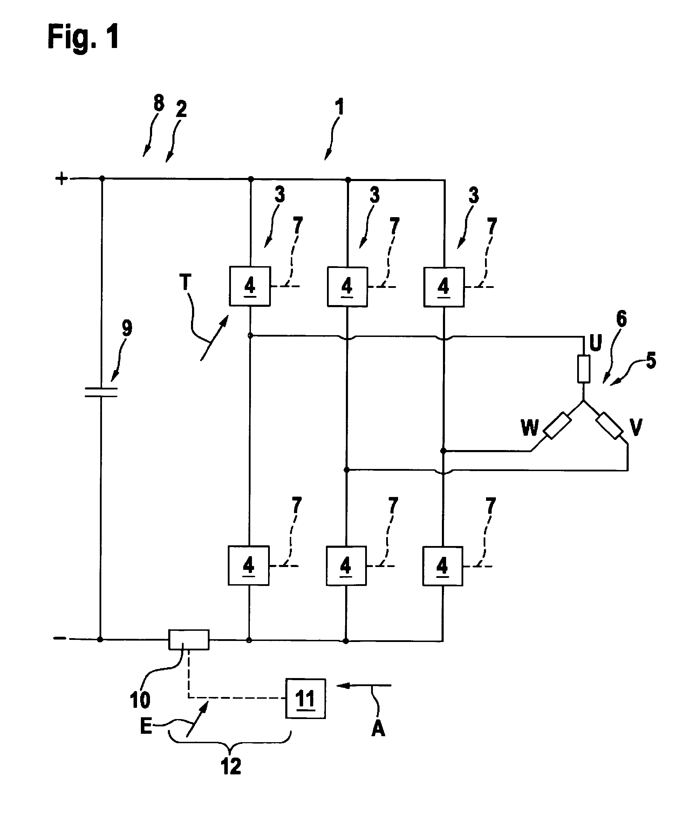

Die Figur 1 zeigt eine Brückenschaltung 1, die an einen Gleichstromkreis 2 angeschlossen ist. Die Brückenschaltung 1 ist als B6-Brücke mit drei Brückenzweigen 3 ausgebildet. Jeder Brückenzweig 3 weist zwei steuerbare Schaltelemente 4 auf. Ein Verbraucher 5, der als dreiphasiger Asynchronmotor 6 ausgebildet ist, wird von der Brückenschaltung 1 angesteuert. Eine nicht dargestellte Steuereinheit erzeugt Ansteuersignale nach bestimmten Taktmustern, wobei die Ansteuersignale Steuereingängen 7 der Schaltelemente 4 zugeführt werden, wodurch diese in den leitenden oder sperrenden Zustand schaltbar sind. Im Gleichstromkreis 2, der als Gleichstromzwischenkreis 8 ausgebildet ist, liegt ein Zwischenkreiskondensator 9. Der Gleichstromkreis 2 ist über einen Shunt 10 mit der Brückenschaltung 1 verbunden.

Zur Strommessung ist nur ein einziger Shunt 10 vorhanden, mit dem in sequenzieller Folge die Phasenströme des Asynchronmotors 6 ermittelt werden können. Vorzugsweise werden zwei Phasenströme der insgesamt drei Phasenströme gemessen und der dritte Phasenstrom mittels der Kirchhoffschen Gesetze berechnet. Es ist ein bestimmtes Schaltmuster, also eine bestimmte Ansteuerung der steuerbaren Schaltelemente 4 erforderlich, damit der Strom durch den gemeinsamen Shunt 10 in der Zu- beziehungsweise Rückleitung vom/zum Gleichstromzwischenkreis 2 dem zu messenden Phasenstrom entspricht. An den Shunt 10 ist eine Messverstärkerschaltung 12 und ein Analog-Digital-Wandler 11 angeschlossen, der das analoge Signal des Shunts 10 in ein digitales Signal umwandelt. Die Messverstärkerschaltung 12 weist im Betrieb eine Einschwingzeit E auf. Der Analog-Digital-Wandler 11 besitzt eine Abtastzeit A und die vorzugsweise als Feldeffekttransistoren (FET) ausgebildeten Schaltelemente 4 besitzen eine Totzeit T.

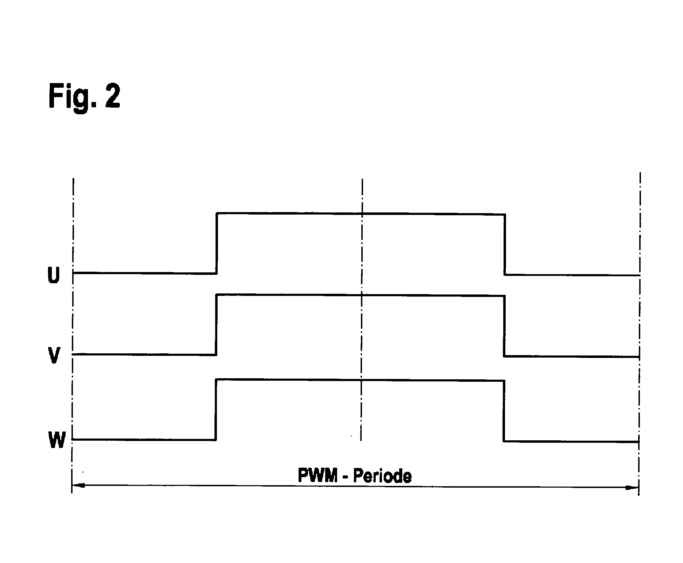

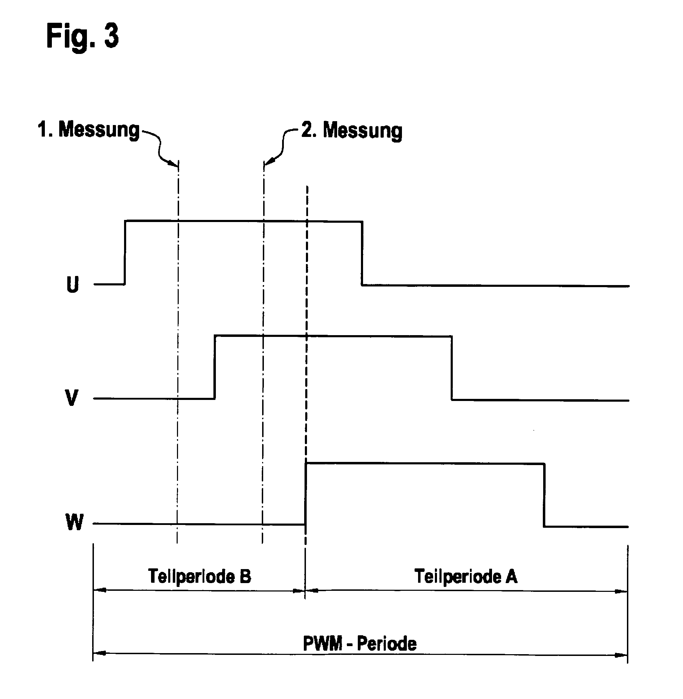

Die Ansteuerung der Schaltelemente 4 mittels der nicht dargestellten Steuereinheit erfolgt nicht gemäß Figur 2, da in dieser Figur eine bekannte mittenzentrierte Pulsweitenmodulation dargestellt ist, das heißt, die dort dargestellten Ansteuersignale bilden ein mittenzentriertes Taktmuster für die einzelnen Phasen U, V und W, innerhalb der in der Figur 2 dargestellten Pulsweitenmodulations-Periode (PWM-Periode). Würde man diese Ansteuerung vornehmen, so ließen sich die Phasenströme des Verbrauchers 5 nicht mit Hilfe eines einzigen Shunts 10 aufgrund der Gleichzeitigkeit ermitteln. Demzufolge wird gemäß Figur 3 dazu übergegangen, dass ein anderes Taktmuster gewählt wird, das heißt, die Schaltzeiten der Schaltelemente 4 werden gemäß Figur 3 zeitlich verschoben, sodass die Messung von mindestens zwei Phasenströmen innerhalb einer Pulsweitenmodulations-Periode möglich ist. Die beiden Messungen sind mit Messung 1 und Messung 2 gekennzeichnet (1. Messung und 2. Messung). Zum Zeitpunkt der 1. Messung entspricht der Strom durch den Shunt 10 dem Strom in der Phase U; zum Zeitpunkt der 2. Messung entspricht der Strom durch den Shunt 10 dem inversen Strom in der Phase W (dies entspricht der Addition der Phasenströme U und V). Die Messungen werden in der Teilperiode B der Pulsweitenmodulations-Periode durchgeführt. An die Teilperiode B schließt sich die Teilperiode A an, wobei die Summe von Teilperiode B und Teilperiode A die Pulsweitenmodulations-Periode ergeben. Ein Vergleich der Figuren 2 und 3 verdeutlicht die Verschiebung der Schaltzeitpunkte der Schaltelemente 4.

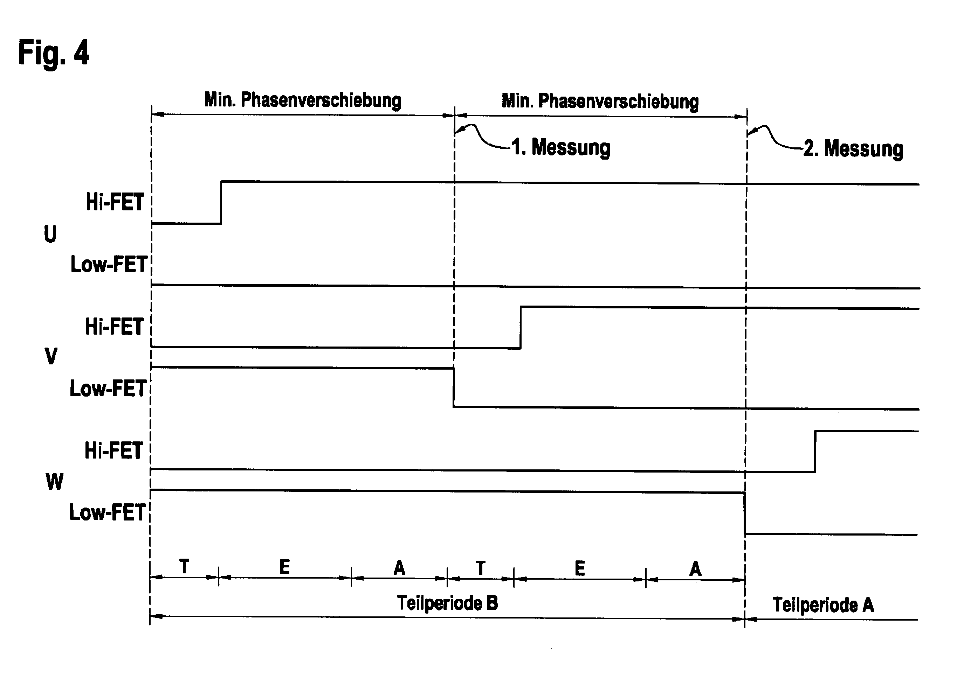

In der Figur 4 ist die Teilperiode B im Detail verdeutlicht. Die Zustände der als Feldeffekttransistoren ausgebildeten Schaltelemente 4 sind mit "Hi-FET" und mit "Low-FET" für die einzelnen Phasen U, V, W gekennzeichnet. Um nun die erste Messung durchführen zu können, sind bevorzugt hardwaremäßige Belange zu berücksichtigen. Hierunter sind die Totzeit T der Schaltelemente 4, die Einschwingzeit E der Messverstärkerschaltung 12 und die Abtastzeit A des Digital-Analog-Wandlers 11 zu verstehen. Werden diese drei Zeiten minimiert, also möglichst klein gemacht, wobei dennoch die jeweilige Funktion gewährleistet ist, so ergibt sich gemäß Figur 4 in der Summe dieser drei Zeiten die mögliche minimale Phasenverschiebung (Min. Phasenverschiebung) für die erste Messung. Am Ende der Abtastzeit A kann dann die erste Messung erfolgen. Entsprechendes gilt für die Durchführung der zweiten Messung, da auch dort zunächst die minimale Totzeit, die minimale Einschwingzeit und die minimale Abtastzeit abgewartet werden müssen, wobei die Summe dieser drei Zeiten die minimale Phasenverschiebung für die zweite Messung ergibt.

Demgemäß errechnet sich die für eine Strommessung nötige Verschiebung bevorzugt wie folgt: Verschiebung = Totzeit des Brückenzweigs + Einschwingzeit der Messverstärkerschaltung + Abtastzeit des Digital-Analog-Wandlers.

Die Teilperiode B ergibt sich somit für zwei Messungen als: Teilperiode B = 2 x Verschiebung.

Die Teilperiode A ist somit:

$$\text{Teilperiode A} = \text{PWM-Periode} - \text{Teilperiode B}.$$

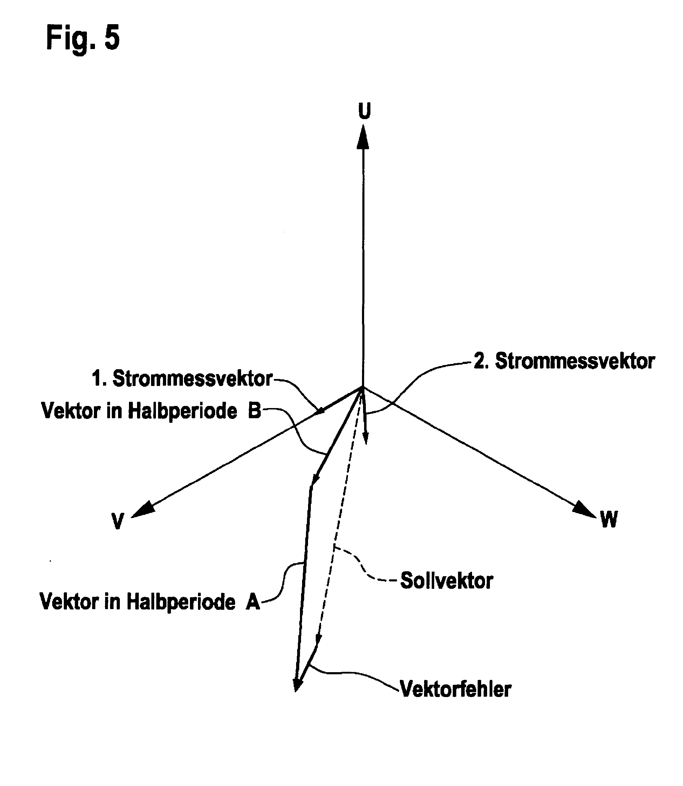

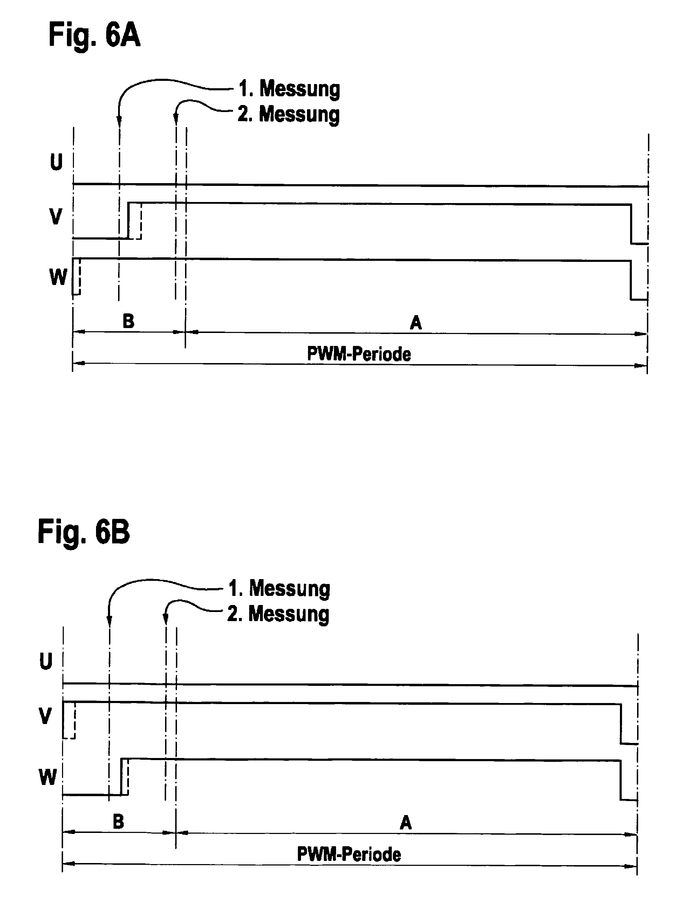

Zum besseren Verständnis ist in Figur 5 ein Zeigerdiagramm dargestellt. Vorteilhafterweise wird gemäß Figur 5 die Phasenlage beziehungsweise Sektorlage für die beiden benötigten Strommessvektoren (1. Strommessvektor und 2. Strommessvektor) beziehungsweise für den resultierenden Strommessvektor (Vektor in Halbperiode B) in Abhängigkeit von der Phasenlage beziehungsweise der Sektorposition des momentenstellenden und feldbildenden Phasenvektors bewirkt beziehungsweise bestimmt. Der resultierende Strommessvektor in der Halbperiode B ergibt sich durch die vektorielle Addition des ersten Strommessvektors mit dem zweiten Strommessvektor. Weiterhin ist ein Soll-Vektor dargestellt, der von der Steuereinheit als Phasenvektor vorgegeben wird, und der als der momentenstellende und feldbildende Vektor anzusehen ist. Durch die Wahl des Sektors für den resultierenden Strommessvektor in Abhängigkeit des Soll-Vektors beziehungsweise Phasenvektors wird die Geräuschbildung verringert und der Kondensatorstrom und die Drehmomentwelligkeit bei der Phasenstrommessung mit nur einem Shunt 10 verringert. Besonders bevorzugt erfolgt die Ansteuerung derart, dass der Strommessvektor mit dem Phasenvektor beziehungsweise dessen Drehwinkelposition mitrotiert. Näheres kann insbesondere der Offenlegungsschrift WO 2008/055741 entnommen werden, die dies im Detail beschreibt. Durch die Wahl der Phasenlagen wird der ebenfalls eingetragene Fehlvektor (Vektorfehler) sehr viel kleiner. Das der Figur 5 entsprechende Taktmuster geht aus der Figur 6A hervor. Es ist zu erkennen, dass unter Anwendung einer geeigneten Phasenwahl beim Messeingriff der Fehlervektor deutlich verkleinert wird. Es würde beim gezeigten Soll-Vektor ganz Null werden, wenn zusätzlich eine Kompensation des Messeingriffs in der Halbperiode A erfolgen würde.

Figuren 6A und 6B zeigen das übliche Vorgehen, wenn ein Umschalten des resultierenden Strommessvektors von einem Sektor in einen anderen Sektor durchgeführt wird. Dazu zeigt Figur 6A das Schaltmuster mit Phasenverschiebung gemäß eines ersten Taktes beziehungsweise einer ersten Pulsweitenmodulations-Periode (PWM-Periode) und Figur 6B das Taktmuster einen Takt später, bei welchem der Sektor durch eine entsprechende Phasenverschiebung der Phasen V und W geändert ist. Durch das Umschalten, in diesem Fall eine Vertauschung von Phasen V und W, von einem Takt zum darauffolgenden Takt werden insbesondere bei niederinduktiven elektrischen Maschinen störend wahrnehmbare Geräusche erzeugt, da die Maschine durch den plötzlichen Spannungssprung angeregt wird. Insbesondere bei Synchronmaschinen kann diese Anregung störend wirken.

Erfindungsgemäß ist daher vorgesehen, dass zum Umschalten des bewirkten Strommessvektors, also des resultierenden Strommessvektors, von einem Sektor des Zeigerdiagramms in einen anderen Sektor die Taktmuster in Teilschritten über mehrere Takte hinweg verschoben werden und die folgende Strommessung erst bei Erreichen des bestimmten beziehungsweise gewünschten Strommessvektors beziehungsweise bei Erreichen der gewünschten Sektorlage erfolgt.

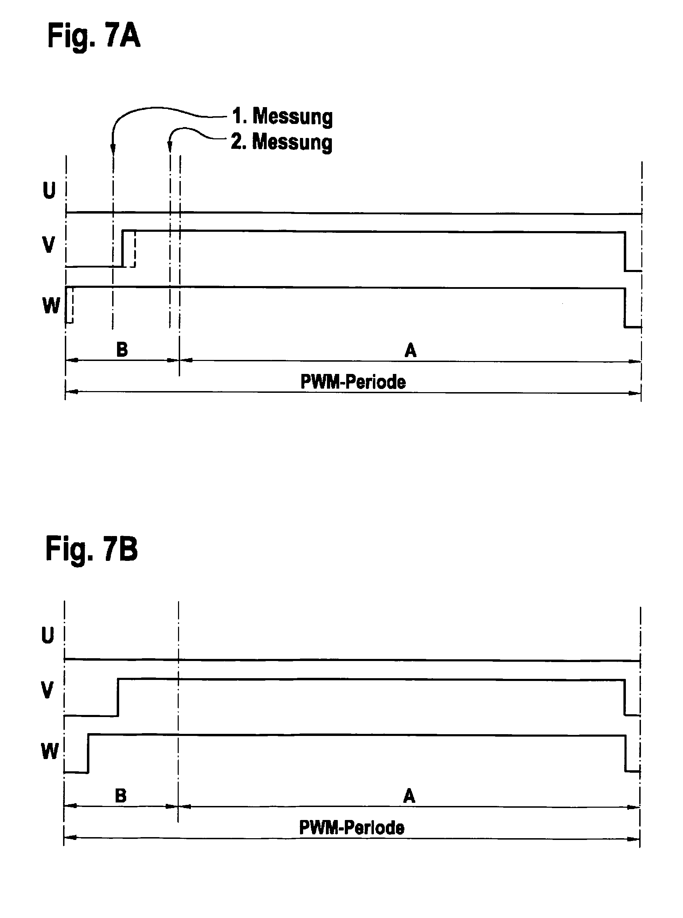

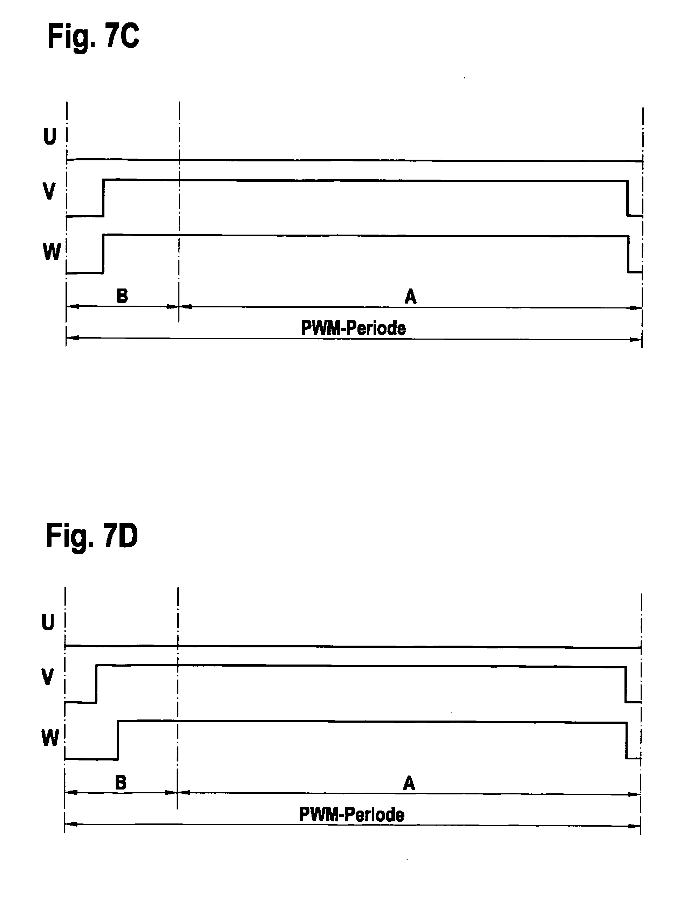

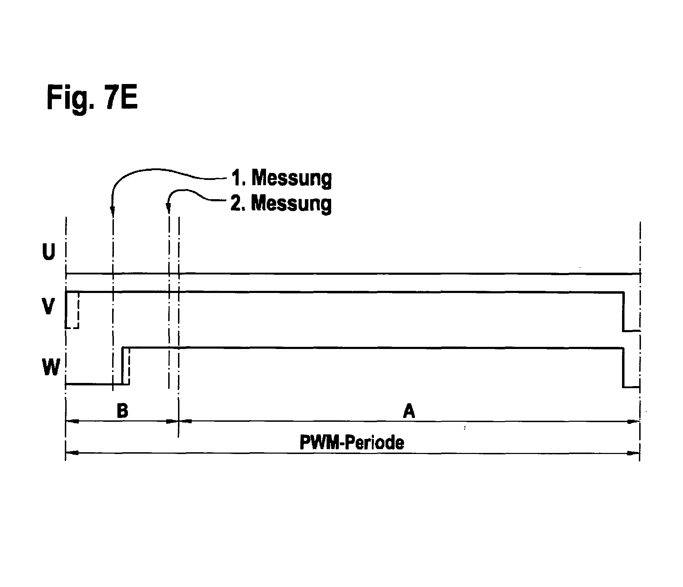

Figuren 7A bis 7E zeigen ein derartiges schrittweises Verschieben beziehungsweise Umschalten des Strommessvektors. Figur 7A stellt die Ausgangssituation dar, in welcher eine erste Strommessung mit einer ersten Messung und einer zweiten Messung, wie oben stehend beschrieben, erfolgt ist. In den darauffolgenden Takten findet zunächst keine Strommessung statt, jedoch wird der Phasenversatz von V und W zueinander verringert, gemäß Figur 7B, bis V und W phasengleich sind, gemäß Figur 7C. In einem weiteren Teilschritt gemäß Figur 7D erfolgt eine weitere Verschiebung der Phasen, sodass ein entgegengesetzter Phasenversatz, insbesondere gespiegelt bezüglich dem in Figur 7B dargestellten Phasenversatz, erreicht wird. Erst im letzten Teilschritt gemäß Figur 7E sind die Taktmuster derart weit verschoben, dass der bewirkte Strommessvektor in dem gewünschten, anderen Sektor liegt und darüber hinaus auch der minimale Phasenversatz zur Strommessung gewährleistet ist. Erst jetzt wird eine weitere Strommessung mit einer ersten Messung und einer zweiten Messung durchgeführt, wie in Figur 7E angezeigt. In dem vorliegenden Ausführungsbeispiel erfolgt die Verschiebung beziehungsweise die Umschaltung des Strommessvektors in mehreren Teilschritten beziehungsweise Teilverschiebungen über vier Takte hinweg. Natürlich können auch mehr oder weniger Takte, mindestens aber ein Zwischentakt, in welchem keine Strommessung erfolgt, vorgesehen sein. Die Abtastung des Stromes erfolgt somit nicht in jeder Schaltperiode des PWM-Musters, sondern, je nach Ausgestaltung, nur alle n, mit beispielsweise n = 16, Taktzyklen der Pulsweitenmodulation. Hierdurch wird der Verbraucher, insbesondere der dreiphasige Asynchronmotor oder alternativ ein Permanentmagnet-Synchronmotor weniger oder nicht angeregt, wodurch insbesondere die Geräuschentwicklung weiter reduziert wird.

**Patentansprüche**

1.    Verfahren zur Strommessung in einem mehrphasigen, insbesondere dreiphasigen Stromnetz, bei dem durch mittels Ansteuersignale ansteuerbaren Schaltelementen (4) eine gewünschte Bestromung eines elektrischen Verbrauchers (5) erfolgt, wobei die Strommessung mit nur einem einzigen Shunt (10) erfolgt und Taktmustern der Ansteuersignale mindestens zwei Messfenster zur sequenziellen Strommessung von Phasenströmen zugeordnet sind und die Taktmuster zeitlich verschoben werden, um Messfenster ausreichender zeitlicher Größe zu erhalten, und um die Sektorlage eines durch die Strommessung bewirkten Strommessvektors in Abhängigkeit von der momentanen Sektorposition des Phasenvektors zu bestimmen, **dadurch gekennzeichnet, dass** nach einer erfolgten Strommessung beim Umschalten des Stromvektors von einem Sektor in einen anderen Sektor die Taktmuster in Teilschritten über mehrere Takte hinweg verschoben werden und die folgende Strommessung erst bei Erreichen des bestimmten Strommessvektors erfolgt.

2.    Verfahren nach Anspruch 1, **dadurch gekennzeichnet, dass** die Strommessung alle x + 1 Takte erfolgt, mit x > 0.

3.    Verfahren nach einem der vorhergehenden Ansprüche, **dadurch gekennzeichnet, dass** das Umschalten des Stromvektors in einen anderen Sektor über mindestens vier Takte erfolgt.

4.    Verfahren nach einem der vorhergehenden Ansprüche, **dadurch gekennzeichnet, dass** als Ansteuersignale Pulsweitenmodulationssignale eingesetzt werden.

5.    Verfahren nach einem der vorhergehenden Ansprüche, **dadurch gekennzeichnet, dass** als Verbraucher ein insbesondere mehrphasiger Asynchronmotor (6) oder ein insbesondere mehrphasiger Permanentmagnet-Synchronmotor bestromt wird.

6. Verfahren nach einem der vorhergehenden Ansprüche, **dadurch gekennzeichnet, dass** in je einem Messfenster die Messung eines Phasenstroms der Verbraucher erfolgt.

7. Verfahren nach einem der vorhergehenden Ansprüche, **dadurch gekennzeichnet, dass** der Strommessvektor derart umgeschaltet wird, dass er mit dem Phasenvektor mitrotiert.

8. Verfahren nach einem der vorhergehenden Ansprüche, **dadurch gekennzeichnet, dass** der Phasenvektor aus der Kombination eines Momenten stellenden und Feld bildenden Vektors resultiert.

9. Verfahren nach einem der vorhergehenden Ansprüche, **dadurch gekennzeichnet, dass** als Schaltelemente (4) elektronische Bauelemente, insbesondere Transistoren und/oder Thyristoren, eingesetzt werden, die insbesondere eine Brückenschaltung (1) bilden.

10. Vorrichtung zur Strommessung in einem mehrphasigen, insbesondere dreiphasigen Stromnetz, insbesondere zur Durchführung des Verfahrens nach einem oder mehreren der vorhergehenden Ansprüche, mit mehreren steuerbaren Schaltelementen (4) zur gewünschten Bestromung eines Verbrauchers (5), sowie mit Mitteln zur Strommessung, wobei die Mittel einen einzigen Shunt (10) sowie eine Ansteuereinheit zum Steuern der Schaltelemente (4) mittels der Ansteuersignale umfassen, wobei zur Strommessung Taktmustern der Ansteuersignale mindestens zwei Messfenster zur sequenziellen Strommessung von Phasenströmen zugeordnet sind und die Taktmuster zeitlich verschoben werden, um Messfenster ausreichender zeitlicher Größe zu erhalten, und um die Sektorlage eines durch die Strommessung bewirkten Strommessvektors in Abhängigkeit von der momentanen Sektorposition des Phasenvektors zu bestimmen, **dadurch gekennzeichnet, dass** nach einer erfolgten Strommessung beim Umschalten des Stromvektors von einem Sektor in einen anderen Sektor die Taktmuster in Teilschritten über mehrere Takte hinweg verschoben werden und die folgende Strommessung erst bei Erreichen des bestimmten Strommessvektors erfolgt.

## Claims

1. Method for measuring current in a polyphase, in particular three-phase, power supply system, in which switching elements (4) which are driveable by means of drive signals are used to energize an electrical consumer (5) in a desired manner, wherein the current is measured using only a single shunt (10) and at least two measurement windows for sequentially measuring phase currents are associated with clock patterns of the drive signals and the clock patterns are shifted in terms of time in order to obtain measuring windows of sufficient time duration and in order to determine the sector position of a current measurement vector, caused by the current measurement, on the basis of the instantaneous sector position of the phase vector, **characterized in that**, after the current has been measured, the clock patterns are shifted in substeps over a plurality of clock cycles when changing over the current vector from one sector to another sector and the current is subsequently measured only when the particular current measurement vector is reached.

2. Method according to Claim 1, **characterized in that** the current is measured every x + 1 clock cycles, where x > 0.

3. Method according to either of the preceding claims, **characterized in that** changing over the current vector to another sector occurs over at least four clock cycles.

4. Method according to any of the preceding claims, **characterized in that** pulse-width-modulation signals are used as drive signals.

5. Method according to any of the preceding claims, **characterized in that** an asynchronous motor (6), in particular polyphase asynchronous motor, or a permanent-magnet synchronous motor, in particular polyphase permanent-magnet synchronous motor, is energized as consumer.

6. Method according to any of the preceding claims, **characterized in that** a phase current of the consumer is measured in each measurement window.

7. Method according to any of the preceding claims, **characterized in that** the current measurement vector is changed over such that it co-rotates with the phase vector.

8. Method according to any of the preceding claims, **characterized in that** the phase vector results from the combination of a moment-causing and field-forming vector.

9. Method according to any of the preceding claims, **characterized in that** electronic components, in particular transistors and/or thyristors, which form, in particular, a bridge circuit (1), are used as switching elements (4).

10. Apparatus for measuring current in a polyphase, in particular three-phase, power supply system, in particular for performing the method according to one or more of the preceding claims, having a plurality of controllable switching elements (4) for energizing a consumer (5) in a desired manner, and means for measuring current, wherein the means comprise a single shunt (10) and a drive unit for controlling the switching elements (4) by means of the drive signals, wherein, to measure the current, at least two measurement windows for sequentially measuring phase currents are associated with clock patterns of the drive signals and the clock patterns are shifted in terms of time in order to obtain measuring windows of sufficient time duration and in order to determine the sector position of a current measurement vector, caused by the current measurement, on the basis of the instantaneous sector position of the phase vector, **characterized in that**, after the current has been measured, the clock patterns are shifted in substeps over a plurality of clock cycles when changing over the current vector from one sector to another sector and the current is subsequently measured only when the particular current measurement vector is reached.

**Revendications**

1. Procédé de mesure du courant dans un réseau électrique multiphasé, notamment triphasé, selon lequel une alimentation électrique souhaitée d'un consommateur (5) électrique est réalisée par des éléments de commutation (4) qui peuvent être commandés à l'aide de signaux d'excitation, la mesure du courant s'effectuant avec un seul et unique shunt (10) et aux moins deux fenêtres de mesure étant associées aux modèles cycliques des signaux d'excitation en vue d'une mesure de courant séquentielle des courants de phase et les modèles cycliques étant décalés dans le temps afin d'obtenir des fenêtres de mesure de durée suffisante et afin de définir la position sectorielle d'un vecteur de mesure de courant produit par la mesure de courant en fonction de la position sectorielle momentanée du vecteur de phase, **caractérisé en ce qu'**après avoir réalisé une mesure de courant, lors de la permutation du vecteur de courant d'un secteur en un autre secteur, les modèles cycliques sont décalés en pas partiels en étant éloignés de plusieurs cycles et la mesure de courant suivante n'a lieu qu'après avoir atteint le vecteur de mesure de courant défini.

2. Procédé selon la revendication 1, **caractérisé en ce que** la mesure de courant est effectué tous les x + 1 cycles, avec x > 0.

3. Procédé selon l'une des revendications précédentes, **caractérisé en ce que** la permutation du vecteur de courant en un autre secteur s'effectue sur au moins quatre cycles.

4. Procédé selon l'une des revendications précédentes, **caractérisé en ce que** les signaux d'excitation utilisés sont des signaux à modulation d'impulsions en largeur.

5. Procédé selon l'une des revendications précédentes, **caractérisé en ce que** le consommateur alimenté électriquement est un moteur asynchrone (6) notamment multiphasé ou un moteur synchrone à aimant permanent notamment multiphasé.

6. Procédé selon l'une des revendications précédentes, **caractérisé en ce que** la mesure d'un courant de phase du consommateur s'effectue à chaque fois dans une fenêtre de mesure.

7. Procédé selon l'une des revendications précédentes, **caractérisé en ce que** le vecteur de mesure de courant est permuté de telle sorte qu'il tourne conjointement avec le vecteur de phase.

8. Procédé selon l'une des revendications précédentes, **caractérisé en ce que** le vecteur de phase résulte de la combinaison d'un vecteur fournissant un moment et formant un champ.

9. Procédé selon l'une des revendications précédentes, **caractérisé en ce que** les éléments de commutation (4) utilisés sont des composants électroniques, notamment des transistors et/ou des thyristors, lesquels forment notamment un circuit en pont (1).

10. Dispositif de mesure du courant dans un réseau électrique multiphasé, notamment triphasé, notamment pour mettre en oeuvre un procédé selon une ou plusieurs des revendications précédentes, comprenant plusieurs éléments de commutation (4) commutables destinés à l'alimentation électrique souhaitée d'un consommateur (5), et comprenant aussi des moyens de mesure de courant, les moyens comprenant un unique shunt (10) ainsi qu'une unité d'excitation pour la commande des éléments de commutation (4) à l'aide des signaux d'excitation, en vue de la mesure de courant, aux moins deux fenêtres de mesure étant associées aux modèles cycliques des signaux d'excitation en vue d'une mesure de courant séquentielle des courants de phase et les modèles cycliques étant décalés dans le temps afin d'obtenir des fenêtres de mesure de durée suffisante et afin de définir la position sectorielle d'un vecteur de mesure de courant produit par la mesure de courant en fonction de la position sectorielle momentanée du vecteur de phase, **caractérisé en ce qu'**après avoir réalisé une mesure de courant, lors de la permutation du vecteur de courant d'un secteur en un autre secteur, les modèles cycliques sont décalés en pas partiels en étant éloignés de plusieurs cycles et la mesure de courant suivante n'a lieu qu'après avoir atteint le vecteur de mesure de courant défini.

# Fig. 1

# Fig. 2

# Fig. 3

# Fig. 4

Min. Phasenverschiebung    Min. Phasenverschiebung

1. Messung    2. Messung

U
Hi-FET
Low-FET

V
Hi-FET
Low-FET

W
Hi-FET
Low-FET

T | E | A | T | E | A

Teilperiode B    Teilperiode A

EP 2 700 156 B1

# Fig. 5

## Fig. 6A

1. Messung
2. Messung

U

V

W

B

A

PWM-Periode

## Fig. 6B

1. Messung
2. Messung

U

V

W

B

A

PWM-Periode

# Fig. 7A

# Fig. 7B

## Fig. 7C

## Fig. 7D

# Fig. 7E

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008055741 A